# EUROPEAN PATENT APPLICATION

(11) **EP 4 657 530 A1**
(43) Date of publication of application: **03.12.2025**
(21) Application number: 24178954.4
(22) Date of filing: 29.05.2024
(51) Int. Cl.: H01L 29/06, H01L 29/40, H01L 29/78

(54) **EDGE TERMINATION STRUCTURE**

(71) Applicant: Nexperia B.V., 6534 AB Nijmegen (NL)
(72) Inventor: Shaw, Andrew, Manchester (GB); Kumar, Ankit, Manchester (GB); Efthymiou, Epameinondas, Manchester (GB); Kim, Hungjin, Shanghai (CN)
(74) Representative: Pjanovic, Ilija

(57) **Abstract**

The present disclosure relates to an edge termination structure suitable for the MOSFET transistor especially in power applications.

An edge termination structure, suitable for the MOSFET transistor, comprising a plurality of parallel strips (1) and at least one a shield oxide filled trench, SOTR, (6) wherein the SOTR (6) is perpendicular to the strips (1) and connects with the stripes (1) at the end portion (12) of the stripes (1).

## Description

### TECHNICAL FIELD

The present disclosure relates to an edge termination structure suitable for the MOSFET transistor especially in power applications.

### BACKGROUND OF THE DISCLOSURE

Document US9680003B2 discloses a solution where a recess is formed at a semiconductor layer of a device to define a plurality of mesas. An active trench portion of the recess residing between adjacent mesas. A termination portion of the trench residing between the end of each mesa and a perimeter of the recess. The transverse spacing between the mesas and the lateral spacing between the mesas and an outer perimeter of a recess forming the mesas are substantially the same. A shield structure within the trench extends from the region between the mesas to the region between the ends of the mesas and the outer perimeter of the recess forming the mesas. A contact resides between a shield electrode terminal and the shield portion residing in the trench.

Document US8889511B2 discloses a method includes forming a shield dielectric layer in a trench in a semiconductor substrate, forming a shield electrode on at least a portion of the shield dielectric layer, and etching the shield dielectric layer so that a portion of the shield dielectric layer is recessed in the trench. The method can include forming a gate dielectric layer on the recessed portion of the shield dielectric layer in the trench, forming a first conductive gate electrode on a first side of the shield electrode and insulated from a first sidewall of the trench by the gate dielectric layer, and forming a second conductive gate electrode on a second side of the shield electrode and insulated from a second sidewall of the trench by the gate dielectric layer.

Accordingly, it is a goal of the present disclosure to provide an improved edge termination structure which provides high area efficiency of the edge termination structure that can enlarge active area and thus improve the current capacity for a given chip area. Manufacturing process of said structure is a cost-effective process as it will reduce one mask used in termination process.

### SUMMARY OF THE DISCLOSURE

According to an example of the disclosure, an edge termination structure, suitable for the MOSFET transistor, comprising a plurality of parallel strips and at least one a shield oxide filled trench, SOTR, wherein the SOTR is perpendicular to the strips and connects with the stripes at the end portion of the stripes.

Preferably there is at least one dummy trench, which is, at least in one part, parallel to the SOTR.

Preferably one of the SOTR 6 forms the end of the strips.

Preferably one SOTR is near the end of the stripes, preferably the SOTR is at most 1µm from the end portion of the stripes.

Preferably there are two of the SOTR parallel to each other, preferably the distance between the SOTR 6 is defined as 1-2 mesa pitches - the distance between the main strip 1

Preferably each of the SOTR consists of shield oxide.

Preferably a depth of each of the SOTR is the same as a depth of the stripes.

Preferably a width of each of the SOTR is within a range of 30-70% of the width of the strip.

### BRIEF DESCRIPTION OF THE DRAWINGS

The disclosure will now be discussed with reference to the drawings, which show in:
Figure 1 shows a prior art solution of a edge termination structure;
Figure 2 shows an edge termination structure according to the disclosure
Figure 3 shows a cross-sections of parts of the edge termination structure according to the disclosure;
Figure 4 shows a first exemplary embodiment of the edge termination structure according to the disclosure;
Figure 5 shows a second exemplary embodiment of the edge termination structure according to the disclosure;
Figure 6 shows a third exemplary embodiment of the edge termination structure according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

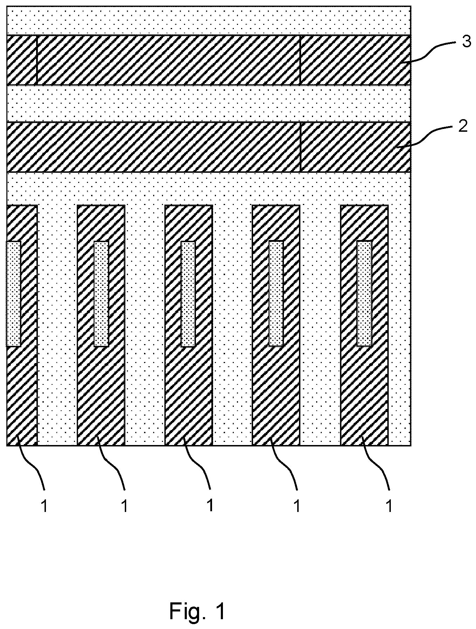

Fig. 1 shows a solution known from the prior art. Near the end of the strips 1 there is a grounded trench 2 behind which there is a dummy trench 3, which is not connected, galvanically, to any electrical potential and thus its electrical potential varies. In such a structure two parameters are important - size of a mesa, that is a distance between strips 1, and a size of a gap, that is a distance between strips 1 and the grounded trench 2.

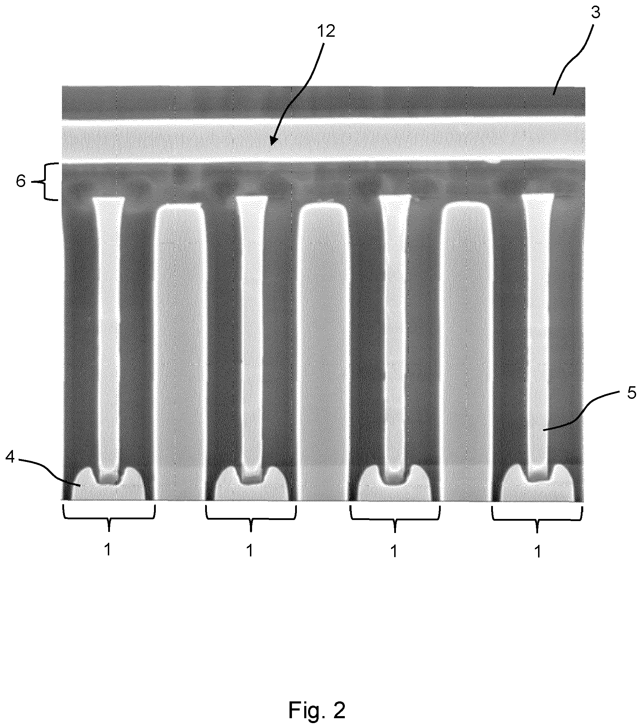

In a edge termination structure according to the disclosure there is a plurality of parallel strips 1 which are connected with at least one shield oxide filled trench, SOTR, 6, which is perpendicular to the strips 1. In such a case, as shown in fig. 2, there is only one parameter which needs to be considered, that is a width of the SOTR 6. Other parts of the strips 1 are also visible - there is visible a gate poly top 4, a shield poly top 5 and shield oxide 8.

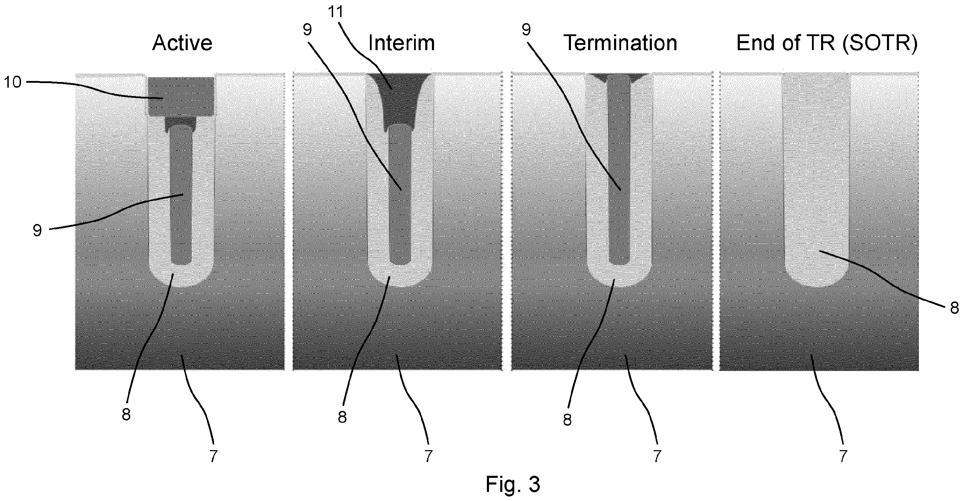

In fig. 3 a cross-section of each part of the edge termination structure is visible. An active cross-section is the most bottom part of the strips 1 as shown in fig. 2 In the substrate 7 the strip 1 is form by a shield oxide 8 in which a shield poly 9 is located on top of which a gate poly 10 is located. An interim part of the strip 1 is located further to toward the end portion 12 of the strip 1. As previously the strip 1 is form by the shield oxide 8 in which the shield poly 9 is located but in this section a HDP oxide 11 is on top of it. A termination portion is located at the end portion 12 of the strip 1 where previously the strip 1 is form by the shield oxide 8 in which the shield poly 9 is located such that it reaches the top part of the strip 1. The SOTR 6 is made as the shield oxide 8 only. It should be noted that in this example SOTR 6 have the same depth as stripe 1. a width of each of the SOTR 6 is within a range of 30-70% of the width of the strip (1). In presented embodiment the SOTR 6 width is within a range of 0,4-1,1µm.

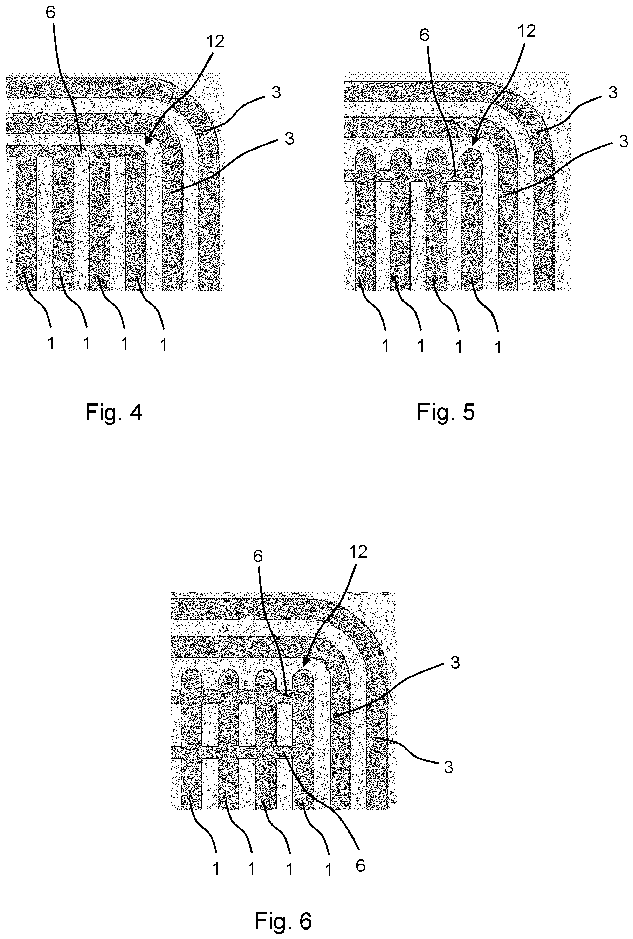

Figures 4-6 shows exemplary embodiments of the present disclosure. On fig. 4 the SOTR 6 is located at the end portion 12 of the strip 1 and there is only one SOTR 6 in this embodiment. Near the strips 1 and SOTR 6 the dummy trench 3 is placed, which is optional - the dummy trenches 3, in general, are used for process uniformity. In this example there are two dummy trenches 3. The dummy trench 3 is, at least in one part, parallel to the SOTR 6. On fig. 5 the SOTR 6 is placed near the end portion 12 of the strip 1, but not at the end - preferably at most 1µm from the end portion 12 of the strip 1, even more preferably at the end portion 12 of the strip 1. In such a case it should be noted that the SOTR 6 width should be calculated here as if it is wider since the protruding end portions 12 of the strips 1 act as wideners of the SOTR 6. In fig. 6 there are two SOTR 6 - one is placed as in fig. 5, and other one is placed further away from the end portions 12 of the strips 1. Both SOTR 6 are parallel in this exemplary embodiment and a distance between them is, in this embodiment, 1.5 -µm, however this dimension may be design such that the distance between the SOTR 6 is smaller or greater. In such a case the edge termination structure is more robust due to the additional SOTR 6 in the design. Preferably the distance between the SOTR 6 is defined as 1-2 mesa pitches - the distance between the main strip 1.

### LIST OF REFERENCE NUMERALS USED

- 1: strip
- 2: grounded trench
- 3: dummy trench
- 4: gate poly top
- 5: shield poly top
- 6: shield oxide filled trench, SOTR
- 7: substrate
- 8: shield oxide
- 9: shield poly
- 10: gate poly
- 11: HDP oxide
- 12: end portion of the strip

## Claims

1. An edge termination structure, suitable for the MOSFET transistor, comprising a plurality of parallel strips (1) and at least one a shield oxide filled trench, SOTR, (6) wherein the SOTR (6) is perpendicular to the strips (1) and connects with the stripes (1) at the end portion (12) of the stripes (1).

2. The edge termination structure according to anyone of the previous claims, wherein there is at least one dummy trench (3), which is, at least in one part, parallel to the SOTR (6).

3. The edge termination structure according to claim 1 or 2, wherein one of the SOTR (6) forms the end of the strips (1).

4. The edge termination structure according to claim 1 or 2, wherein one SOTR (6) is near the end of the stripes (1), preferably the SOTR (6) is at most 1µm from the end portion of the stripes (1).

5. The edge termination structure according to claim 3 or 4, wherein there are two of the SOTR (6) parallel to each other, preferably a distance between the SOTRs (6) is µm defined as 1-2 mesa pitches - the distance between the main strip 1.

6. The edge termination structure according to anyone of the previous claims, wherein each of the SOTR (6) consists of shield oxide (8).

7. The edge termination structure according to anyone of the previous claims, wherein a depth of each of the SOTR (6) is the same as a depth of the stripes (1).

8. The edge termination structure according to anyone of the previous claims, wherein a width of each of the SOTR (6) is within a range of 30-70% of the width of the strip (1).
